# EUROPÄISCHE PATENTSCHRIFT

(11) **EP 1 003 358 B1**
(45) Veröffentlichungstag und Bekanntmachung des Hinweises auf die Patenterteilung: **01.06.2005**
(21) Anmeldenummer: 99122724.0
(22) Anmeldetag: 16.11.1999
(51) Int. Cl.: H05K 3/32, H05K 3/34

(54) **Verfahren zur Kontaktierung eines Bauelements und Schaltungsanordnung**
Process for connecting a component and circuit assembly
Procédé de connexion d'un composant et assemblage de circuit

(30) Priorität: 18.11.1998 DE 19853153
(43) Veröffentlichungstag der Anmeldung: 24.05.2000
(73) Patentinhaber: Grundig Multimedia B.V., 1083HJ Amsterdam (NL)
(72) Erfinder: Weidel, Günther, 90762 Fürth (DE)
(74) Vertreter: Pröll, Jürgen

(56) Entgegenhaltungen:
- US-A- 3 912 852
- US-A- 4 300 184
- US-A- 5 611 884

## Beschreibung

Die Erfindung betrifft ein Verfahren zur Kontaktierung eines Bauelements nach dem Oberbegriff des Anspruchs 1. Sie betrifft ferner eine Schaltungsanordnung nach dem Oberbegriff des Anspruchs 9.

Ein solches Verfahren und eine solche Schaltungsanordung werden in der US-A-4 300 184 gezeigt.

Nach dem Stand der Technik werden schwere Bauelemente, wie Sperrwandler, Leistungstransistoren, Transformatoren und dgl., mittels einer Lötverbindung auf einem Schaltungsträger, z.B. einer Platine, montiert. Die Lötverbindung solcher Bauelemente ist im Betrieb thermischen und mechanischen Belastungen, z.B. Vibrationen, ausgesetzt. Diese Belastungen können zum Bruch der Lötverbindung führen, wodurch ein Kontakt zwischen einem Kontaktelement des Bauelements und einer auf dem Schaltungsträger vorgesehenen Kontaktfläche unterbrochen wird.

Zur Behebung dieses Nachteils werden derzeit alternativ zwei Maßnahmen ergriffen:

Bei einer ersten Maßnahme wird die maschinell im Wellenlötverfahren hergestellte Lötverbindung bzw. Lötstelle durch nochmaliges Aufbringen von Lot im sogenannten Nachlötverfahren verstärkt.

Nach einer zweiten Maßnahme wird ein im Bereich der schaltungsträgerseitigen Kontaktfläche vorgesehener Durchbruch vor der Herstellung der Lötverbindung mit einer Niete verstärkt.
Durch die vorgenannten Maßnahmen wird zwar die Zeit bis zum Bruch der Lötstelle verlängert. Das Problem eines Kontaktverlusts durch den Bruch der Lötstelle wird jedoch nicht grundsätzlich beseitigt.

Aufgabe der Erfindung ist es, die Nachteile nach dem Stand der Technik zu beseitigen. Es sollen insbesondere ein Verfahren sowie eine Schaltungsanordnung angegeben werden, mit denen ein Kontaktverlust thermisch und mechanisch belasteter Lötstellen vermieden werden kann.

Diese Aufgabe wird durch die Merkmale der Ansprüche 1 und 9 gelöst. Zweckmäßige Ausgestaltungen ergeben sich aus den Merkmalen der Ansprüche 2 bis 8 und 10 bis 16.

Nach Maßgabe der Erfindung ist verfahrensseitig vorgesehen, dass die Lötstelle nach der Erstarrung der Lötlegierung mit einem leitfähigen Polymer überdeckt wird.

So kann selbst bei einem Bruch der Lötstelle ein Kontakt zwischen dem Kontaktelement und der Kontaktfläche aufrechterhalten werden: Die Rissufer im Bereich der Lotlegierung werden durch das elastische Polymer unter Aufrechterhaltung eines elektrischen Kontakts überbrückt.

Das erfindungsgemäße Verfahren lässt sich relativ einfach und mit geringem Kostenaufwand durchführen. Es ist einer Massenproduktion zugänglich.

Nach einem Ausgestaltungsmerkmal enthält das Polymer, vorzugsweise 75 bis 85 Gew.%, Silber. Ein solches hochgefülltes Polymer hat besonders gute Kontakteigenschaften.

Das Polymer kann eine Dichte von 3,1 bis 3,9 g/cm³ aufweisen. Von Vorteil ist es, dass das Polymer eine Glasumwandlungstemperatur im Bereich von 35 bis 45°C hat. Es kann ein Kunstharz, vorzugsweise ein Epoxid-Harz, sein. Ein Polymer mit den vorgenannten Eigenschaften lässt sich besonders einfach verarbeiten.

Nach einem weiteren Ausgestaltungsmerkmal wird die Viskosität des Polymers auf 10 bis 50 Pas eingestellt. Das gewährleistet die erforderlichen Fließeigenschaften zur vollflächigen Überdeckung der Lötstelle.

Das Polymer kann mittels einer Spendeeinrichtung bzw. einem Dispenser auf die Lötstelle aufgebracht werden. Das ermöglicht eine kostengünstige automatisierte Verfahrensführung.

Als besonders vorteilhaft wird es angesehen, das Polymer so aufzutragen, dass es die Lötstelle vollflächig abdeckt und sich bis auf einen die Lötstelle umgebenden Randbereich der Kontaktfläche erstreckt. Das gewährleistet selbst bei einem kontaktflächenseitigen Bruch der Lötstelle eine besonders sichere Kontaktierung des Bauelements.

Nach weiterer Maßgabe der Erfindung ist bei einer Schaltungsanordnung vorgesehen, dass die Lötstelle mit einem leitfähigen Polymer überdeckt ist. - Die Kontaktierung einer solchen Schaltungsanordnung zeichnet sich durch eine hohe Zuverlässigkeit aus. Selbst bei einem Bruch der Lötstelle bleibt der elektrische Kontakt aufrechterhalten.

Nachfolgend werden Ausgestaltungen der Erfindung anhand eines Ausführungsbeispiels näher erläutert.

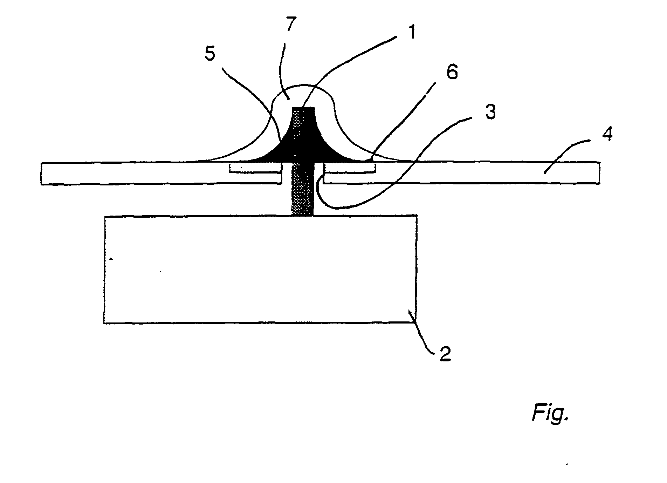

Die einzige Figur zeigt eine schematische Teilquerschnittsansicht einer Schaltungsanordnung.

Dabei durchgreift ein Kontaktstift 1 eines Bauelements 2 einen Durchbruch 3 eines Schaltungsträgers 4. Beim Schaltungsträger 4 kann es sich um eine Platine oder auch ein Chassis eines Fernsehgerätes oder dgl. handeln.

Eine durch einen Lötminiskus gebildete Lötstelle 5 verbindet elektrisch leitend eine auf dem Schaltungsträger 4 angebrachte Kontaktfläche 5 mit dem Kontaktstift 2. Die Kontaktfläche 5 kann Bestandteil einer gedruckten Leiterbahn sein.

Die Lötstelle 5 ist vollflächig mit einer aus einem leitfähigen Polymer 7 hergestellten Schicht überdeckt. Das, vorzugsweise etwa 81 Gew.%, Silber enthaltende Polymer 7 erstreckt sich insbesondere auch auf den Randbereich der Kontaktfläche 6, welcher nicht von der Lötlegierung überdeckt ist.

Als Polymer 7 können sowohl ein- als auch zweikomponentige leitfähige Harze verwendet werden. Solche Polymere 7 sind z.B. unter der eingetragenen Marke Dotite von der Firma Fujikura Kasei Co., Ltd. oder unter der Produktbezeichnung "PC 870007" von der Firma Heraeus erhältlich.

Das Polymer 7 kann mittels eines Dispensers auf die zu sichernde Lötstelle 5 aufgetragen werden. Dazu wird die Viskosität des Polymers 7 zweckmäßigerweise auf 10 bis 50 Pas eingestellt. Zur Automatisierung dieses Vorgangs kann ein Roboter zum Einsatz kommen.

Der Dispenser kann vorteilhafterweise mit einer Rührvorrichtung versehen sein. Dadurch wird eine Entmischung des leitfähigen Polymers 7 während des Verarbeitungsprozesses vermieden.

Zur Beschleunigung der Aushärtung des Polymers 7 kann es nach dem Auftragen einer Temperaturbehandlung ausgesetzt werden. Die dabei aufgebrachten Temperaturen von 50 bis 70°C können durch Umspülen der Lötstelle mit Heißluft oder durch Infrarotstrahlung erzeugt werden. Sie liegen oberhalb der Glasumwandlungstemperatur des Polymers 7, die etwa 35°C bis 45°C beträgt.

### Bezugszeichenliste

- 1: Kontaktstift
- 2: Bauelement
- 3: Durchbruch
- 4: Schaltungsträger
- 5: Lötstelle
- 6: Kontaktfläche
- 7: Polymer

## Patentansprüche

1. Verfahren zur Kontaktierung eines Bauelements (2), insbesondere eines Sperrwandlers, Leistungstransistors und dgl., wobei mindestens ein Kontaktelement (1) des Bauelements (2) mittels einer schmelzflüssigen Lotlegierung mit einer auf einem Schaltungsträger (4) vorgesehenen Kontaktfläche (6) unter Bildung einer Lötstelle (3) kontaktiert wird,
**dadurch gekennzeichnet,**
**dass** die Lötstelle (5) nach der Erstarrung der Lötlegierung mit einem leitfähigen Polymer (7) überdeckt wird.

2. Verfahren nach Anspruch 1,
wobei das Polymer (7), vorzugsweise 75 - 85 Gew.%, Silber enthält.

3. Verfahren nach einem der vorhergehenden Ansprüche,
wobei das Polymer (7) eine Dichte von 3,1 bis 3,9 g/cm³ aufweist.

4. Verfahren nach einem der vorhergehenden Ansprüche,
wobei das Polymer (7) eine Glasumwandlungstemperatur im Bereich von 35 bis 45 °C hat.

5. Verfahren nach einem der vorhergehenden Ansprüche,
wobei das Polymer (7) ein Kunstharz, vorzugsweise ein Epoxid-Harz, ist.

6. Verfahren nach einem der vorhergehenden Ansprüche,
wobei die Viskosität des Polymers (7) auf 10 bis 50 Pas eingestellt wird.

7. Verfahren nach einem der vorhergehenden Ansprüche,
wobei das Polymer (7) mittels einer Spendeeinrichtung auf die Lötstelle (5) aufgebracht wird.

8. Verfahren nach einem der vorhergehenden Ansprüche,
wobei das Polymer (7) so aufgetragen wird, dass es die Lötstelle (5) vollflächig abdeckt und sich bis auf einen die Lötstelle (5) umgebenden Randbereich der Kontaktfläche (6) erstreckt.

9. Schaltungsanordnung, bei der mindestens ein Kontaktelement (1) des Bauelements (2), insbesondere eines Sperrwandlers, Leistungstransistors und dgl., mittels einer schmelzflüssigen Lotlegierung mit einer auf einem Schaltungsträger (4) vorgesehenen Kontaktfläche (6) unter Bildung einer Lötstelle (5) kontaktiert ist,
**dadurch gekennzeichnet,**
**dass** die Lötstelle (5) mit einem leitfähigen Polymer (7) überdeckt ist.

10. Schaltungsanordnung nach Anspruch 9,
wobei das Polymer (7), vorzugsweise 75 - 85 Gew.%, Silber enthält.

11. Schaltungsanordnung nach einem der Ansprüche 9 oder 10,
wobei die Viskosität des Polymers (7) beim Aufbringen auf die Lötstelle (5) 10 bis 50 Pas beträgt.

12. Schaltungsanordnung nach einem der Ansprüche 9 bis 11,
wobei das Polymer (7) mittels einer Spendeeinrichtung auf die Lötstelle (5) aufbringbar ist.

13. Schaltungsanordnung nach einem der Ansprüche 9 bis 12,
wobei das Polymer (7) eine Dichte von 3,1 bis 3,9 g/cm³ aufweist.

14. Schaltungsanordnung nach einem der Ansprüche 9 bis 13,
wobei das Polymer (7) eine Glasumwandlungstemperatur im Bereich von 35 bis 45°C hat.

15. Schaltungsanordnung nach einem der Ansprüche 9 bis 14,
wobei das Polymer (7) ein Kunstharz, vorzugsweise ein Epoxid-Harz, ist.

16. Schaltungsanordnung nach einem der Ansprüche 9 bis 15,
wobei das Polymer (7) so aufgetragen ist, dass es die Lötstelle (5) vollflächig abdeckt und sich bis auf einen die Lötstelle (5) umgebenden Randbereich erstreckt.

## Claims

1. A method for contacting a component (2), in particular an isolating transformer, power transistor or the like, at least one contact element (1) of the component (2) being contacted by means of a molten solder alloy with a contact surface (6) provided on a circuit carrier (4), thereby forming a soldered joint (5),
**characterised in that**
the soldered joint (5) is covered with a conductive polymer (7) after the solder alloy has solidified.

2. A method according to claim 1,
wherein the polymer (7) contains silver, preferably 75 - 85 wt.% thereof.

3. A method according to one of the preceding claims,
wherein the polymer (7) exhibits a density of 3.1 to 3.9 g/cm³.

4. A method according to one of the preceding claims,
wherein the polymer (7) has a glass transition temperature in the range of from 35 to 45°C.

5. A method according to one of the preceding claims,
wherein the polymer (7) is a synthetic resin, preferably an epoxy resin.

6. A method according to one of the preceding claims,
wherein the viscosity of the polymer (7) is adjusted to 10 to 50 Pas.

7. A method according to one of the preceding claims,
wherein the polymer (7) is applied to the soldered joint (5) by means of a dispensing means.

8. A method according to one of the preceding claims,
wherein the polymer (7) is applied in such a way that it covers the whole surface of the soldered joint (5) and extends as far as an edge area of the contact surface (6) surrounding the soldered joint (5).

9. A circuit arrangement, in which at least one contact element (1) of the component (2), in particular an isolating transformer, power transistor or the like, is contacted by means of a molten solder alloy with a contact surface (6) provided on a circuit carrier (4), thereby forming a soldered joint (5),
**characterised in that**
the soldered joint (5) is covered with a conductive polymer (7).

10. A circuit arrangement according to claim 9,
wherein the polymer (7) contains silver, preferably 75 - 85 wt.% thereof.

11. A circuit arrangement according to one of claims 9 or 10,
wherein the viscosity of the polymer (7) upon application onto the soldered joint (5) amounts to 10 to 50 Pas.

12. A circuit arrangement according to one of claims 9 to 11,
wherein the polymer (7) may be applied to the soldered joint (5) by means of a dispensing device.

13. A circuit arrangement according to one of claims 9 to 12,
wherein the polymer (7) exhibits a density of 3.1 to 3.9 g/cm³.

14. A circuit arrangement according to one of claims 9 to 13,
wherein the polymer (7) has a glass transition temperature in the range of from 35 to 45°C.

15. A circuit arrangement according to one of claims 9 to 14,
wherein the polymer (7) is a synthetic resin, preferably an epoxy resin.

16. A circuit arrangement according to one of claims 9 to 15,
wherein the polymer (7) is applied in such a way that it covers the whole surface of the soldered joint (5) and extends as far as an edge area surrounding the soldered joint (5).

## Revendications

1. Procédé de connexion d'un composant (2) (en particulier d'un convertisseur à oscillateur bloqué, transistor de puissance ou autre composant similaire), dans lequel au moins un élément de contact (1) du composant (2) est connecté, au moyen d'un alliage de brasage fusible, à une surface de contact (6) prévue sur un support de circuit (4) en formant un joint brasé (5),
**caractérisé en ce que**
le joint brasé (5) est recouvert, après solidification de l'alliage de brasage, d'un polymère (7) conducteur;

2. Procédé selon la revendication 1,
dans lequel le polymère (7) contient de préférence de 75 à 85 % en poids d'argent.

3. Procédé selon l'une quelconque des revendications précédentes,
dans lequel le polymère (7) présente une densité de 3,1 à 3,9 g/cm³.

4. Procédé selon l'une quelconque des revendications précédentes,
dans lequel le polymère (7) possède une température de vitrification comprise entre 35 et 45°C.

5. Procédé selon l'une quelconque des revendications précédentes,
dans lequel le polymère (7) est une résine synthétique, et de préférence une résine d'époxyde.

6. Procédé selon l'une quelconque des revendications précédentes,
dans lequel la viscosité du polymère (7) est ajustée à 10 à 50 Pas.

7. Procédé selon l'une quelconque des revendications précédentes,
dans lequel le polymère (7) est appliqué sur le joint brasé (5) au moyen d'un dispositif de distribution.

8. Procédé selon l'une quelconque des revendications précédentes,
dans lequel le polymère (7) est mis en place de telle manière qu'il recouvre le joint brasé (5) sur toute sa surface et s'étend jusqu'à une zone de bord, entourant le joint brasé (5), de la surface de contact (6).

9. Assemblage de circuit dans lequel au moins un élément de contact (1) du composant (2) (en particulier d'un convertisseur à oscillateur, transistor de puissance ou autre composant similaire) est connecté, au moyen d'un alliage de brasage fusible, à une surface de contact (6) prévue sur un support de circuit (4) en formant un joint brasé (5),
**caractérisé en ce que**
le joint brasé (5) est recouvert d'un polymère conducteur (7).

10. Assemblage de circuit selon la revendication 9,
dans lequel le polymère contient de préférence de 75 à 85 % en poids d'argent.

11. Assemblage de circuit selon l'une quelconque des revendications 9 ou 10,
dans lequel la viscosité du polymère (7), lors de son application sur le joint brasé (5), vaut de 10 à 50 Pas.

12. Assemblage de circuit selon l'une quelconque des revendications 9 à 11,
dans lequel le polymère (7) peut être appliqué sur je joint brasé (5) au moyen d'un dispositif de distribution.

13. Assemblage de circuit selon l'une quelconque des revendications 9 à 12,
dans lequel le polymère présente une densité de 3,1 à 3,9 g/cm³.

14. Assemblage de circuit selon l'une quelconque des revendications 9 à 13,
dans lequel le polymère possède une température de vitrification comprise entre 35 et 45°C.

15. Assemblage de circuit selon l'une quelconque des revendications 9 à 14,
dans lequel le polymère est une résine synthétique, et de préférence une résine d'époxyde.

16. Assemblage de circuit selon l'une quelconque des revendications 9 à 15,
dans lequel le polymère (7) est mis en place de telle manière qu'il recouvre le joint brasé (5) sur toute sa surface et s'étend jusqu'à une zone de bord, entourant le joint brasé (5), de la surface de contact (6).
